# EUROPEAN PATENT APPLICATION

(11) **EP 4 534 483 A1**
(43) Date of publication of application: **09.04.2025**
(21) Application number: 23887156.0
(22) Date of filing: 27.10.2023
(51) Int. Cl.: C01G 33/00, C01G 23/00, C04B 35/499, C04B 35/626, C30B 35/00, C30B 29/22

(54) **PREPARATION METHOD FOR MAGNESIUM NIOBATE**

(30) Priority: 14.08.2023 CN 202311019095
(71) Applicant: Beijing Sinoma Synthetic Crystals Co., Ltd., Beijing 100018 (CN); China National Building Material Group Co., Ltd., Beijing 100036 (CN); Sinoma Synthetic Crystals Co., Ltd., Beijing 100018 (CN)
(72) Inventor: TONG, Yaqi, Beijing 100018 (CN); ZHENG, Yu, Beijing 100018 (CN); LI, Hui, Beijing 100018 (CN)
(74) Representative: Bardehle Pagenberg Partnerschaft mbB Patentanwälte Rechtsanwälte
(86) International application number: PCT/CN2023/127098
(87) International publication number: WO 2025/035584

(57) **Abstract**

The present application provides a preparation method of magnesium niobate, comprising: mixing MgO and Nb₂O₅ uniformly by wet ball milling, and drying to obtain a mixed powder; water-quenching the mixed powder after raising its temperature to 1500 °C to 1700 °C in 1 h to 3 h to obtain solid particles of core-shell structure encapsulations; and raising the temperature of the solid particles to 1000 °C to 1200 °C and holding the temperature to obtain the magnesium niobate. The present application provides solid particles of a core-shell structure encapsulation through a water-quenching process, then raising the temperature of the obtained particles rapidly and sintering, MN with high purity, high stability, high homogeneity of both Mg²⁺ and Nb⁵⁺ components, and high reactivity is obtained, which is conducive to fully mix MgNb₂O₆, PbO and TiO₂ to form the liquid phase at high temperature and thus form raw materials for PMNT crystals growth with better purity and homogeneity, further contributing to obtain a PMNT single crystal with a single perovskite structure, high purity and excellent piezoelectric properties, and thus improving the yield.

## Description

This application claims the benefit of priority of Chinese Patent Application No. CN202311019095.7, with the title of "METHOD OF PREPARING MAGNESIUM NIOBATE", filed on August 14, 2023 before the CNIPA, which is incorporated herein by reference in its entirety.

### TECHNICAL FIELD OF THE INVENTION

The present application relates to the technical field of piezoelectric materials, in particular to a method of preparing magnesium niobate.

### BACKGROUND OF THE INVENTION

Lead magnesium niobate-lead titanate (PMNT) is a typical perovskite ferroelectric with excellent piezoelectric properties, the piezoelectric constant d₃₃ of which is 4 to 5 times that of PZT ceramics, thereby having a wide range of applications in the fields of medical ultrasonic imaging, sonar, underwater sound transducer and the like. However, raw materials for crystal growth with high-purity are required to obtain a high-quality PMNT single crystal.

Currently, raw materials for preparing PMNT are mainly synthesized via a two-step process, firstly synthesizing magnesium niobate (MN) precursor by a solid-phase reaction between niobium pentoxide (Nb₂O₅) and magnesium oxide (MgO), followed by reacting the MN precursor with titanium oxide (TiO₂) and lead oxide (PbO) to obtain the raw materials for PMNT growth. However, during the preparation of MN precursor, there exists a problem of incomplete reaction between MgO and Nb₂O₅, making free niobium to be easily present in MN, thus leading to the reaction between residual Nb₂O₅ and PbO to form the second phase of Pb₂Nb₂O₇ (pyrochlore phase), and the coexistence of pyrochlore phase with principal crystalline phase of perovskite may seriously decrease the piezoelectric properties of PMNT single crystals, impeding the full utilization of the material properties. Therefore, finding a method for synthesizing magnesium niobate with high-purity is the key to improve the purity of the raw materials for crystal growth.

### SUMMARY OF THE INVENTION

An object of the present application is to provide a method of preparing magnesium niobate enable to improve the purity and stability of the prepared magnesium niobate. Specific technical solutions are as follows:
A first aspect of the present application provides a method of preparing magnesium niobate, comprising the following steps:
(1) mixing MgO and Nb₂O₅ uniformly by wet ball milling, and drying to obtain a mixed powder;
(2) water-quenching the mixed powder after raising its temperature to 1500 °C to 1700 °C in 1 h to 3 h to obtain solid particles of core-shell structure encapsulations; and
(3) raising the temperature of the solid particles to 1000 °C to 1200 °C and holding the temperature to obtain the magnesium niobate.

In some embodiments of the present application, the molar ratio of MgO to Nb₂O₅ is 1:1.

In some embodiments of the present application, MgO has a Dv50 particle size of 50 nm to 100 nm.

In some embodiments of the present application, Nb₂O₅ has a Dv50 particle size of 2 µm to 15 µm.

In some embodiments of the present application, the mass ratio of grinding balls, materials to be milled, and ball milling medium used in the wet ball milling is 1: (0.9 to 1.1): (1.2 to 1.8).

In some embodiments of the present application, the materials of the ball milling jar for the wet ball milling are polyurethane.

In some embodiments of the present application, the ball milling medium for the wet ball milling is anhydrous ethanol.

In some embodiments of the present application, the grinding balls for the wet ball milling are alumina balls.

In some embodiments of the present application, the rotational speed for the wet ball milling is 100 r/min to 200 r/min and the duration time for the wet ball milling is 20 h to 30 h.

In some embodiments of the present application, the rate of raising the temperature to 1000 °C to 1200 °C is 5 °C/min to 10 °C/min.

In some embodiments of the present application, the time of holding the temperature is 25 min to 35 min.

In some embodiments of the present application, the solid particles have a Dv50 particle size of 0.5 mm to 2 mm.

In some embodiments of the present application, the temperature for drying is 90 °C to 110 °C.

A second aspect of the present application provides a method of preparing raw materials for lead magnesium niobate-lead titanate (PMNT) growth, comprising the method of preparing magnesium niobate as described in the first aspect of the present application.

Beneficial effects of the present application are as follows:
The present application adopts wet ball milling, which is able to make the obtained slurry more homogeneous, and provides a core-shell structure encapsulation through a water-quenching process, i.e., the outside of MgO is uniformly encapsulated by Nb₂O₅, leading to a larger contact area and a stronger bonding force therebetween. The structure allows the solid-phase reaction between the core and the shell portions of the solid particles more complete in the subsequent rapid raising the temperature and sintering process, and allows obtaining magnesium niobate (MgNb₂O₆, MN) with high purity, high stability, high homogeneity of both Mg²⁺ and Nb⁵⁺ components, and high reactivity, which is conducive to fully mix with MgNb₂O₆, PbO and TiO₂ to form a liquid phase at high temperature and thus form the raw materials for lead magnesium niobate-lead titanate (PMNT) crystals growth with better purity and homogeneity, further contributing to obtain a PMNT single crystal with a single perovskite structure, high purity and excellent piezoelectric properties, and thus improving the yield.

Of course, all of the advantages described above do not have to be achieved at the same time when any of the products or methods of the present application is implemented.

### BRIEF DESCRIPTION OF THE DRAWINGS

In order to more clearly illustrate the technical solutions in the embodiments of the present application or prior art, the drawings that need to be used in the description of the embodiments or prior art will be briefly introduced in the following, and it will be obvious that the drawings in the following description are only some of the embodiments of the present application, and that other embodiments can be obtained according to these drawings for those skilled in the art.
FIG. 1 shows a schematic diagram of the structure of the solid particles of core-shell structure encapsulations prepared by the present application;
FIG. 2 shows an X-ray diffraction pattern of the magnesium niobate product prepared in Example 1;
FIG. 3 shows an X-ray diffraction pattern of the magnesium niobate product prepared in Comparative Example 4.

### DETAILED DESCRIPTION

The technical solutions in the embodiments of the present application will be described clearly and completely in the following in conjunction with the accompanying drawings in the embodiments of the present application, and it is obvious that the described embodiments are only a part of the embodiments of the present application, and not all of the embodiments. All other embodiments obtained by those skilled in the art on the basis of the present application fall within the scope of protection of the present application.

A first aspect of the present application provides a method of preparing magnesium niobate, characterized in comprising the following steps:
(1) mixing MgO and Nb₂O₅ uniformly by wet ball milling, and drying to obtain a mixed powder;
(2) water-quenching the mixed powder after raising its temperature to 1500 °C to 1700 °C in 1 h to 3 h to obtain a solid particle of a core-shell structure encapsulation; and
(3) raising the temperature of the solid particles to 1000 °C to 1200 °C and holding the temperature to obtain the magnesium niobate.

The method of preparing magnesium niobate provided in the present application does not have the problem of incomplete reaction between MgO and Nb₂O₅, and free niobium does not be present in the prepared magnesium niobate, so that the second phase of Pb₂Nb₂O₇ (pyrochlore phase) may not be generated during the subsequent reaction between Nb₂O₅ and PbO.

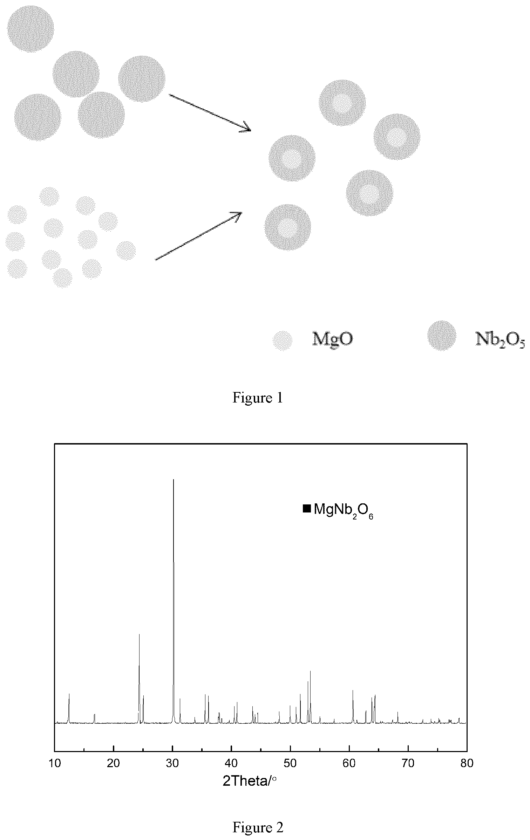

The present application adopts wet ball milling, which is able to make the obtained slurry more homogeneous, and provides a core-shell structure encapsulation through a water-quenching process, i.e., the outside of magnesium oxide is uniformly encapsulated by niobium pentoxide (structural schematic diagram is shown in FIG. 1), leading to a larger contact area and a stronger bonding force therebetween. The structure allows the solid-phase reaction between the core and the shell portions of the solid particles more complete in the subsequent rapid raising the temperature and sintering process, and allows obtaining magnesium niobate (MgNb₂O₆, MN) with high purity, high stability, high homogeneity of both Mg²⁺ and Nb⁵⁺ components, and high reactivity, and without free niobium, which is conducive to fully mix with MgNb₂O₆, PbO and TiO₂ to form a liquid phase at high temperature and thus form the raw materials for lead magnesium niobate-lead titanate (PMNT) crystals growth with better purity and homogeneity, further contributing to obtain a PMNT single crystal with a single perovskite structure, high purity, excellent piezoelectric properties, and thus improving the yield.

In some embodiments of the present application, the initial raw materials MgO and Nb₂O₅ are high-purity reagents with a purity of greater than 99.99%. When the purity of the initial raw materials MgO and Nb₂O₅ is within the above range, the influence of impurities on the purity of the magnesium niobate can be avoided, and thus the quality of the magnesium niobate can be improved.

As the initial raw materials used in the present application, MgO is preferably highly active nanoscale MgO, and Nb₂O₅ is preferably microscale Nb₂O₅.

In the present application, there are no particular limitations on the specific operation methods and the devices used for raising the temperature of the mixed powder to 1500 °C to 1700 °C in 1 h to 3 h, as long as the object of the present application can be achieved, for example, the mixed powder may be placed in a crucible, then put into a high-temperature melting furnace and raising the temperature to 1500 °C to 1700 °C in 1 h to 3 h.

Raising the temperature to 1500 °C to 1700 °C in 1 h to 3 h in the present application is carried out at a constant rate, and the initial temperature before raised is room temperature. When the raising duration time and the temperature after raised for the mixed powder are controlled within the above range, it allows MgO and Nb₂O₅ to form the core-shell structure encapsulations sufficiently, and the magnesium niobate obtained after rapid raising and sintering has a higher purity and greater reactivity.

The room temperature described in this application refers to the indoor temperature, which is generally about 25 °C.

In the present application, there are no particular limitations on the specific operation methods of water-quenching, as long as the object of the present application can be achieved, for example, the mixed powder may be rapidly released from the high-temperature melting device after high-temperature treatment, flowed into the room-temperature water, and water-quenched to obtain solid particles.

In the present application, there are no particular limitations on the specific operation methods and devices used for raising the temperature of the solid particles to 1000 °C to 1200 °C, as long as the object of the present application can be achieved, for example, the solid particles may be placed in a high-temperature electric furnace and heated from room temperature to 1000 °C to 1200 °C.

In some embodiments of the present application, the molar ratio of MgO to Nb₂O₅ is 1:1. When the molar ratio of MgO to Nb₂O₅ is controlled at the above ratio, the incomplete reaction between MgO and Nb₂O₅ can be better avoided.

In some embodiments of the present application, MgO has a Dv50 particle size of 50 nm to 100 nm. When the Dv50 particle size of MgO is controlled within the above range, it allows the slurry obtained by milling more homogeneous, so that the reaction in the subsequent process is more sufficient, and the purity of the produced magnesium niobate is higher.

In some embodiments of the present application, Nb₂O₅ has a Dv50 particle size of 2 µm to 15 µm. When the Dv50 particle size of Nb₂O₅ is controlled within the above range, it allows the mixed powder obtained by milling more homogeneous, so that the reaction in the subsequent process is more sufficient, and the purity of the produced magnesium niobate is higher.

In some embodiments of the present application, the mass ratio of grinding balls, materials to be milled, and ball milling medium used in the wet ball milling is 1: (0.9 to 1.1): (1.2 to 1.8). When the mass ratio of the grinding balls, the materials, and the ball milling medium is controlled within the above range, it allows the mixing of MgO and Nb₂O₅ more homogeneous, so that the reaction in the subsequent process is more sufficient, and the purity of the produced magnesium niobate is higher.

In some embodiments of the present application, the materials of the ball milling jar for the wet ball milling are polyurethane. The selection of polyurethane as the materials for the ball milling jars in this application enables the slurry obtained by milling to be more homogeneous and enables it possible to avoid the introduction of new impurities better .

In some embodiments of the present application, the ball milling medium for the wet ball milling is anhydrous ethanol. The selection of anhydrous ethanol as the ball milling medium enables the slurry obtained by milling more homogeneous, so that the reaction in the subsequent process is more sufficient, and the purity of the produced magnesium niobate is higher.

In some embodiments of the present application, the grinding balls for the wet ball milling are alumina balls. The selection of alumina balls as the grinding balls in this application enables the slurry obtained by milling more homogeneous, so that the reaction in the subsequent process is more sufficient, and the purity of the produced magnesium niobate is higher.

In some embodiments of the present application, the rotational speed for the wet ball milling is 100 r/min to 200 r/min and a duration time for the wet ball milling is 20 h to 30 h. When the rotational speed and duration time of wet ball milling are controlled within the above range, it allows the mixing of MgO and Nb₂O₅ more homogeneous, so that the reaction in the subsequent process is more sufficient and the purity of the produced magnesium niobate is higher.

In some embodiments of the present application, the temperature for drying is 90 °C to 110 °C. When the temperature for drying is controlled within the above range, it allows the slurry to be dried more fully after mixing homogeneously by the wet ball milling. In the present application, there are no particular limitations on the duration time for drying, as long as the object of the present application can be achieved, for example, the duration time for drying may be 20 h to 30 h.

In some embodiments of the present application, a rate of raising the temperature to 1000 °C to 1200 °C is 5 °C/min to 10 °C/min. The temperature of the solid particles before raising in the present application is room temperature. When the rate of raising the temperature of the solid particles of the core-shell structure encapsulations is controlled within the above range, rapid raising and sintering can be achieved, which allows the solid-phase reaction between the core and shell portions of the solid particles more complete and the purity of the produced magnesium niobate is higher.

In some embodiments of the present application, the time of holding the temperature is 25 min to 35 min. When the time is controlled within the above range, it allows the solid-phase reaction occurring between the core and shell portions of the solid particles more complete and the purity of the produced magnesium niobate higher.

In some embodiments of the present application, the solid particle has a Dv50 particle size of 0.5 mm to 2 mm. When the Dv50 particle size of the produced solid particles is within the above range, the reactivity is higher, allowing a better reaction between the solid particles, titanium oxide and lead oxide, and it possible to obtain raw materials for PMNT growth with better purity and homogeneity.

A second aspect of the present application provides a method of preparing a raw material for PMNT growth, comprising the method of preparing magnesium niobate as described in the first aspect of the present application.

The raw materials for PMNT growth can be obtained by reacting the magnesium niobate obtained in the first aspect of the present application with titanium oxide (TiO₂) and lead oxide (PbO).

### EXAMPLES

Hereinafter, Examples and Comparative Examples are given to illustrate more specifically the embodiments of the present application. Various tests and evaluations were carried out according to the method described below. In addition, "portions" and "%" are used as quality standards unless otherwise specified.

The MgO and Nb₂O₅ used in the following Examples and Comparative Examples are high purity reagents with a purity of 99.99%, wherein MgO is highly active nanoscale MgO, Nb₂O₅ is microscale Nb₂O₅ with Dv50 particle size of 10.5 µm.

### Assay of X-ray Diffraction Pattern:

The prepared magnesium niobate was determined using an X-ray powder diffractometer (model: Bruker D8 Advance) (Cu Kα), wherein the scanning range 2θ is 10° to 80°, the scanning rate is 6°/min, and the assay temperature is 20 ± 5 °C.

### Example 1

MgO (Dv50 particle size of 50 nm) and Nb₂O₅ were weighed at a molar ratio of 1:1 and subjected to wet ball milling in a ball mill at a rotational speed of 150 r/min for 24 h to obtain a slurry, which was then dried at 100 °C for 24 h to obtain a mixed powder; wherein the materials for ball milling jars used in wet ball milling were polyurethane, the ball milling medium was anhydrous ethanol, the grinding balls were alumina balls, and the mass ratio of grinding balls, materials to be milled and ball milling medium was 1:1:1.5.

The above dried mixed powder was placed in a crucible, which was put into a high-temperature melting furnace, heated it from room temperature to 1600 °C in 120 min, then the mixture was rapidly released from the bottom of the melting furnace, flowed into water at room temperature, and water-quenched it to obtain solid particles having a Dv50 particle size of 1.5 mm.

The solid particles were put into a high-temperature electric furnace, heated it from room temperature to 1100 °C at a raising rate of 8 °C/min and held the temperature for 30 min to obtain the magnesium niobate.

### Examples 2 to 4

Examples 2 to 4 were performed in steps similar to Example 1 except that the preparation parameters were adjusted to those shown in Table 1.

### Comparative Examples 1 to 3

Comparative Examples 1 to 3 were performed in steps similar to Example 1 except that the preparation parameters were adjusted to those shown in Table 1.

**Table 1 Preparation parameters and products in Examples 1 to 4 and Comparative Examples 1 to 3**

| | Mass ratio of grinding balls, materials to be milled and ball milling medium | Rotational speed and duration time for the wet ball milling | Raising the temperature process | Dv50 particle size of Raw materials | Whether magnesium niobate products have residual |
|---|---|---|---|---|---|
| | | | | | Nb₂O₅ |
| Example 1 | 1:1:1.5 | 150 r/min, 24 h | Raising the temperature from room temperature to 1600 °C in 120 min | MgO 50 nm | No |
| Example 2 | 1:0.9:1.2 | 100 r/min, 30 h | Raising the temperature from room temperature to 1700 °C in 150 min | MgO 60 nm | No |
| Example 3 | 1:1.1:1.8 | 150 r/min, 20 h | Raising the temperature from room temperature to 1650 °C in 150 min | MgO 80 nm | No |
| Example 4 | 1:1:1.5 | 150 r/min, 24 h | Raising the temperature from room temperature to 1600 °C in 180min | MgO 90 nm | No |
| Compara tive Example 1 | 1:1:1.5 | 150 r/min, 24 h | Raising the temperature from room temperature to 1000 °C in 360 min, then raising the temperature to 1200 °C in 100 min and holding for 360 min, lowering the temperature to 300 °C in 240 min, then lowering the temperature to room temperature in 120 min | MgO 1.5 µm | Yes, small amount |
| Compara tive Example 2 | 1:1:1 | 150 r/min, 24 h | Raising the temperature from room temperature to 1000 °C in 360 min, then raising the temperature to 1200 °C in 100 min and holding for 300 min, lowering the temperature to 300 °C in 240 min, then lowering the temperature to room temperature in 120 min | MgO 1.5 µm | Yes, trace amount |
| Compara tive Example 3 | 1:1:1.5 | 80 r/min, 24 h | Raising the temperature from room temperature to 1000°C in 360min, then raising the temperature to 1200°C in 100min and holding for 420min, lowering the temperature to 300°C in 240min, then lowering the temperature to room temperature in 120min | MgO 1.8 µm | Yes, trace amount |

The X-ray diffraction pattern of the magnesium niobate product obtained in Example 1 is shown in FIG. 2, from which it can be seen that the magnesium niobate product prepared in Example 1 has a single crystalline phase, indicating that the magnesium niobate obtained by the method of the present application has a high purity of the crystalline phase, and does not contain any impurities, which is conducive to further obtaining a PMNT single crystal with high purity and excellent piezoelectric properties.

As can be seen from Table 1, the mass ratio of grinding balls, materials to be milled and ball milling medium, the rotational speed and duration time for the wet ball milling, the raising process of the temperature of the mixed powders, and the Dv50 particle size of raw materials MgO in Examples 1 to 4 are controlled within the scope of the present application, the crystalline phases of the prepared magnesium niobate product are all single phase, and there is no residual niobium pentoxide (Nb₂O₅).

The raising process of the temperature of the mixed powder and Dv50 particle size of MgO in Comparative Example 1 are not controlled within the scope of this application, resulting in a trace amount of residual niobium pentaoxide (Nb₂O₅) in the prepared magnesium niobate product as raw materials for the subsequent reaction, which may lead to a reaction between residual Nb₂O₅ and PbO to generate pyrochlore phase and thus a low purity of the crystalline phase of the prepared PMNT single crystal, thereby affecting the properties of the obtained PMNT single crystal.

The mass ratio of grinding balls, materials to be milled and ball milling medium, raising process of the temperature of the mixed powder and Dv50 particle size of MgO in Comparative Example 2 are not controlled within the scope of this application and the rotational speed for the wet ball milling, the raising process of the temperature and Dv50 particle size of MgO in Comparative Example 3 are not controlled within the scope of this application, resulting in a trace amount of residual niobium pentaoxide (Nb₂O₅) in the prepared magnesium niobate product as raw materials for the subsequent reaction, which may lead to a reaction between residual Nb₂O₅ and PbO to generate pyrochlore phase and thus a low purity of the crystalline phase of the prepared PMNT single crystal, thereby affecting the properties of the obtained PMNT single crystal.

### Comparative Example 4

MgO and Nb₂O₅ were weighed at a molar ratio of 1:1 and subjected to wet ball milling in a ball mill at a rotational speed of 150 r/min for 24 h to obtain a slurry; wherein the materials for ball milling jars used in wet ball milling were polyurethane, the ball milling medium was anhydrous ethanol, the grinding balls were alumina balls, and the mass ratio of grinding balls, materials to be milled and ball milling medium was 1:1:1.5. The slurry was dried and placed in a corundum crucible, which was capped and sealed, and put into a box-type electric furnace, the temperature was raised from room temperature to 1000 °C in 360 min, then raised to 1200 °C in 120 min and holded for 360 min, then lowered to 300 °C in 240 min, and lowered to room temperature in 120 min to obtain the magnesium niobate product.

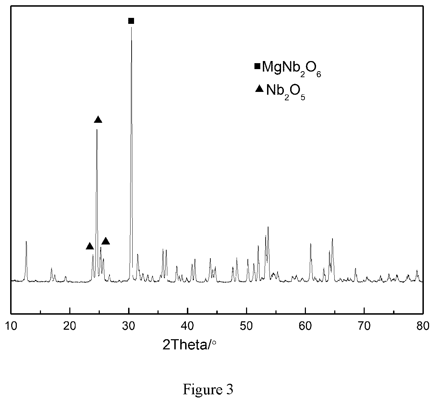

The X-ray diffraction pattern of the obtained magnesium niobate product is shown in FIG. 3, from which it can be seen that the prepared magnesium niobate product in Comparative Example 4 contains residual niobium pentaoxide (Nb₂O₅) in addition to magnesium niobate, indicating that the magnesium niobate product, prepared by the traditional synthetic method provided in Comparative Example 4, as raw materials for the subsequent reaction, may lead to a reaction between part of residual Nb₂O₅ and PbO to generate pyrochlore phase and thus lead to a low purity of the crystalline phase of the prepared PMNT single crystal, thereby affecting the properties of the obtained PMNT single crystal.

The foregoing are only preferred Examples of the present application and are not intended to limit the scope of protection of the present application, and any modifications, equivalent substitutions, improvements and the like made within the spirit and principles of the present application are included in the scope of protection of the present application.

## Claims

1. A method of preparing magnesium niobate, comprising the following steps:
(1) mixing MgO and Nb₂O₅ uniformly by wet ball milling, and drying to obtain a mixed powder;
(2) water-quenching the mixed powder after raising its temperature to 1500 °C to 1700 °C in 1 h to 3 h to obtain a solid particle of a core-shell structure encapsulation; and
(3) raising the temperature of the solid particle to 1000 °C to 1200 °C and holding the temperature to obtain the magnesium niobate.

2. The method of claim 1, **characterized in that** MgO has a Dv50 particle size of 50 nm to 100 nm.

3. The method of claim 1, **characterized in that** Nb₂O₅ has a Dv50 particle size of 2 µm to 15 µm.

4. The method of claim 1, **characterized in that** the mass ratio of grinding balls, materials to be milled, and ball milling medium used in the wet ball milling is 1: (0.9 to 1.1): (1.2 to 1.8).

5. The method of claim 1, **characterized in that** the rotational speed for the wet ball milling is 100 r/min to 200 r/min and a duration time for the wet ball milling is 20 h to 30 h.

6. The method of claim 1, **characterized in that** a rate of raising the temperature of the solid particle to 1000 °C to 1200 °C is 5 °C/min to 10 °C/min.

7. The method of claim 1, **characterized in that** the time of holding the temperature is 25 min to 35 min.

8. The method of claim 1, **characterized in that** the solid particle has a Dv50 particle size of 0.5 mm to 2 mm.

9. The method of any one of claims 1 to 8, **characterized in that** a temperature for drying is 90 °C to 110 °C.

10. A method of preparing a raw material for PMNT growth, comprising the method of preparing magnesium niobate according to any one of claims 1 to 9.
